# EUROPEAN PATENT SPECIFICATION

(11) **EP 2 065 934 B1**
(45) Date of publication and mention of the grant of the patent: **27.07.2011**
(21) Application number: 08169493.7
(22) Date of filing: 20.11.2008
(51) Int. Cl.: H01L 23/367, H01L 23/373, H01L 23/473

(54) **Heat dissipation apparatus**
Wärmeableitungsvorrichtung
Appareil de dissipation thermique

(30) Priority: 21.11.2007 JP 2007302175
(43) Date of publication of application: 03.06.2009
(73) Proprietor: Kabushiki Kaisha Toyota Jidoshokki, Kariya-shi, Aichi 448-8671 (JP); Showa Denko K.K., Tokyo 105-8518 (JP)
(72) Inventor: Mori, Shogo, Kariya-shi Aichi 448-8671 (JP); Yamauchi, Shinobu, Oyama-shi Tochigi 323-8678 (JP); Tamura, Shinobu, Oyama-shi Tochigi 323-8678 (JP)
(74) Representative: TBK

(56) References cited:
- WO-A-2005/098338
- WO-A-2006/109660
- WO-A-2007/007602
- WO-A-2007/105580
- DE-A1- 10 315 225
- "SUBMERGED HEATSINK COMPONENT COOLING" IBM TECHNICAL DISCLOSURE BULLETIN, US,, vol. 34, no. 12, 1 May 1992 (1992-05-01), pages 387-388, XP000308563 ISSN: 0018-8689

## Description

### BACKGROUND OF THE INVENTION

The present invention relates to a heat dissipation apparatus.

Japanese Laid-Open Patent Publication Nos. 2006-294699 and 2001-148451 each describe an example of a heat dissipation apparatus for a power module that includes a semiconductor device such as an insulated gate bipolar transistor (IGBT).

In Japanese Laid-Open Patent Publication No. 2006-294699, a stress reduction member, which includes a plurality of through holes, is arranged between an insulation substrate and a heat sink. The insulation substrate includes a surface for receiving a heated body. In Japanese Laid-Open Patent Publication No. 2001-148451, a buffer layer is arranged between an insulation substrate and a heat sink. The buffer layer is formed from aluminum silicon carbide (AlSiC), the thermal expansion coefficient of which is between that of the insulation substrate and that of the heat sink.

However, AlSiC is a material that is more expensive than aluminum (Al), which is used for heat sinks and the like. Thus, the use of AlSiC in a buffer layer as described in Japanese Laid-Open Patent Publication No. 2001-148451 would increase costs. Further, in the stress reduction member of Japanese Laid-Open Patent Publication No. 2006-294699, the plurality of through holes decrease the thermal conduction area. Thus, the stress reduction member increases the thermal resistance. This may hinder the transfer of heat from the heated body to the heat sink.

W02006/109660 discloses a heat radiator which includes an insulating substrate whose first side serves as a heat-generating-element-mounting side, and a heat sink fixed to a second side of the insulating substrate and which radiates, from the heat sink, heat generated from a heat-generating-element, such as a semiconductor device, mounted on the insulating substrate.

W02007/072700 a semiconductor module provided with a ceramic substrate, a front metal plate and a rear metal plate which are joined on the two surfaces, a the front surface and a rear surface, of the substrate, respectively, and a heat dissipating apparatus joined to the rear metal plate.

### SUMMARY OF THE INVENTION

The objective of the present invention is to provide a heat dissipation apparatus that lowers costs and reduces stress while preventing the thermal resistance from increasing.

One aspect of the present invention is a heat dissipation apparatus including an insulation substrate having a first surface serving as a heated body receiving surface and a second surface opposite to the first surface, with a metal circuit layer formed on the first surface and a metal layer of aluminum formed on the second surface. A heat sink is thermally coupled to the second surface of the insulation substrate. The heat sink is formed from aluminum and serves as a liquid cooling device including a cooling passage. A heat mass member is formed from aluminum and arranged between the metal layer of the insulation substrate and the heat sink. The heat mass member is metal-bonded to the insulation substrate and the heat sink. The heat mass member includes a stress reduction portion and a heat mass portion arranged so that one is above the other. The stress reduction portion includes a plurality of recesses in at least either one of a surface facing toward the insulation substrate of the heat mass member and a surface facing toward the heat sink. The heat mass portion has a thickness that is greater than that of the stress reduction portion, and the heat mass member has a thickness that is greater than three millimeters.

Other aspects and advantages of the present invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a longitudinal cross-sectional view showing a preferred embodiment of a heat dissipation apparatus according to the present invention;
Fig. 2 is a graph showing the variation of the thermal resistance as time elapses during a simulation;
Figs. 3A to 3C are cross-sectional views, each showing a sample used in the simulation of Fig. 2;
Fig. 4 is a longitudinal cross-sectional view showing a heat dissipation apparatus of another example;
Fig. 5 is a longitudinal cross-sectional view showing a heat dissipation apparatus of a further example; and
Fig. 6 is a longitudinal cross-sectional view showing a heat dissipation apparatus of a comparative example.

### DETAILED DESCRIPTION OF THE PREFERRED EMBODIMENTS

A preferred embodiment of heat dissipation apparatus for a power module installed in a vehicle according to the present invention will now be discussed. Hereafter, the term "aluminum" includes aluminum alloys in addition to pure aluminum.

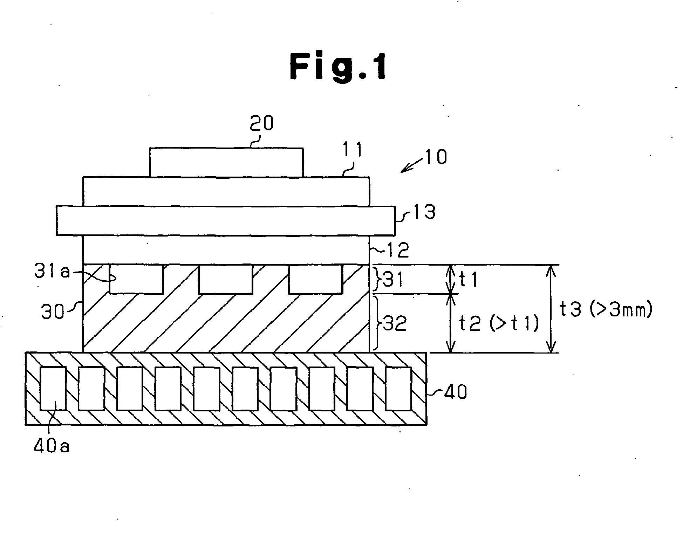

As shown in Fig. 1, the heat dissipation apparatus includes an insulation substrate 10 and a heat sink 40. The insulation substrate 10 includes a first surface (upper surface), which serves as a heated body receiving surface, and a second surface opposite to the first surface. A heat mass member 30 thermally couples the heat sink 40 and the insulation substrate 10.

The insulation substrate 10 includes an insulation ceramic substrate 13, a metal circuit layer 11, and a metal layer 12. The metal circuit layer 11 is formed on a first surface (heated body receiving surface) of the ceramic substrate 13. The metal layer 12 is formed from aluminum on a second surface of the ceramic substrate 13. The ceramic substrate 13 is formed from, for example, aluminum nitride, alumina, silicon nitride, or the like.

A semiconductor device 20 (semiconductor chip), which serves as a heated body, is soldered and bonded to the heated body receiving surface of the insulation substrate 10. An IGBT, MOSFET, diode, or the like may be used as the semiconductor device 20.

The heat sink 40 is formed from a metal having superior heat dissipation properties such as aluminum. The heat sink 40 is low, flat, and hollow. A coolant passage 40a extends through the heat sink 40 so as to meander in a manner that parts of the coolant passage 40a are parallel to one another. Coolant flows through the coolant passage 40a. In this manner, the heat sink 40 functions as a liquid type cooling device that includes the coolant passage 40a, which serves as a cooling passage. The coolant passage 40a includes an inlet and an outlet, which are connectable to a coolant circuit arranged in the vehicle. In a normal heating state (normal state) in which the semiconductor device 20 is driven, the heat generated by the semiconductor device 20 is transferred to the heat sink 40 through the insulation substrate 10 and the heat mass member 30. This smoothly dissipates the heat.

The heat mass member 30, which is formed from aluminum, is arranged between the metal layer 12 of the insulation substrate 10 and the heat sink 40. The heat mass member 30 is metal-bonded to the insulation substrate 10 and the heat sink 40. More specifically, the insulation substrate 10, the heat mass member 30, and the heat sink 40 are brazed and bonded together.

The heat mass member 30 includes a stress reduction portion 31 and a heat mass portion 32, which are arranged so that one is above the other. The stress reduction portion 31 is located in the side facing toward the insulation substrate 10 and includes a plurality of recesses 31a that open toward the insulation substrate 10. The stress reduction portion 31 has a thickness t1, and the heat mass portion 32 has a thickness t2 that is greater than the thickness t1 of the stress reduction portion 31. The heat mass member 30 as a whole has a thickness t3, which is greater than three millimeters.

The heat mass portion 32 has a predetermined heat capacity so as to receive the heat of the semiconductor device 20, which is thermally coupled to the heat mass member 30, when the temperature of the semiconductor device 20 increases.

The heat mass portion 32 functions to temporarily - absorb the heat generated by the semiconductor device 20 and then release the heat to the heat sink 40. The heat capacity of the heat mass portion 32 is set so that when the semiconductor device 20 generates more heat than that generated in a normal heating state, the heat mass portion 32 temporarily absorbs some of the heat and prevents the semiconductor device 20 from overheating.

For example, in an inverter used to control a driving motor for a hybrid vehicle, when the vehicle is suddenly accelerated or suddenly stopped from a normal driving state, the heat generated by the semiconductor device 20 causes the inverter to experience heat loss that is three to five times greater than the normal rating within a short period of less than one second. In the present embodiment, even when using such an inverter, the cooling ability of the heat dissipation apparatus is set so that the temperature of the semiconductor device 20 does not exceed the upper limit of the operational temperature. The heat loss becomes excessive when the vehicle suddenly stops because a large current flows during a regenerative operation.

The operation of the heat dissipation apparatus will now be discussed.

The heat dissipation apparatus is installed in a power module for a hybrid vehicle. The heat sink 40 is connected to a coolant circuit (not shown) by pipes. A pump and a radiator are arranged in the coolant circuit. The radiator includes a fan rotated by a motor and efficiently radiates heat.

When the semiconductor device 20 is driven on the heat dissipation apparatus, the semiconductor device 20 generates heat. In a normal state (normal heating state), the heat generated by the semiconductor device 20 is transferred to the heat sink 40 through the insulation substrate 10 and the heat mass member 30 so that heat is exchanged with the coolant flowing through the heat sink 40. That is, the heat transferred to the heat sink 40 is further transferred and released to the coolant that flows through the coolant passage 40a. The heat sink 40 is forcibly cooled by the coolant flowing through the coolant passage 40a. Thus, the temperature gradient increases in the heat transfer route extending from the semiconductor device 20 to the heat sink 40, and the heat generated by the semiconductor device 20 is efficiently dissipated through the insulation substrate 10 and the heat mass member 30.

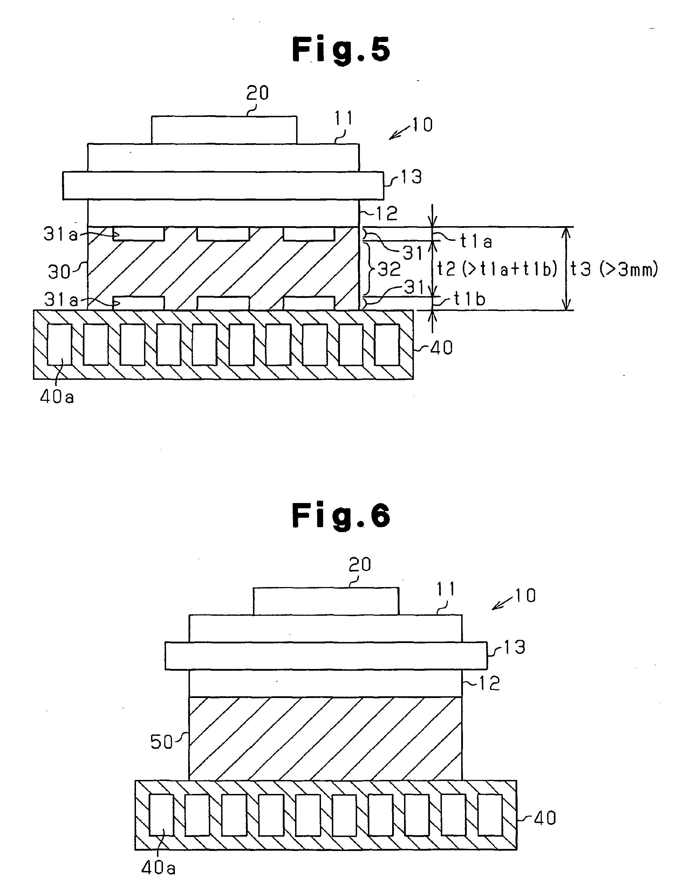

The heat mass member 30 includes the stress reduction portion 31, which has the recesses 31a. The structure of the stress reduction portion 31 reduces thermal stress when a heated body generates heat. More specifically, to reduce thermal stress, the heat mass member 30 is formed from aluminum, which is more cost-effective than AlSiC, the thermal expansion coefficient of which is between that of the insulation substrate 10 and that of the heat sink 40. Referring to Fig. 6, when using an aluminum heat mass member 50 that does not include the recesses 31a of Fig. 1, thermal stress cannot be reduced. In the structure of Fig. 6, if the heat mass member 50 were to be formed from AlSiC, the cost of the heat dissipation apparatus would be high. In the embodiment of Fig. 1, the heat mass member 30, which is formed from cost-effective aluminum, is used to reduce thermal stress when the semiconductor device 20 generates heat.

When the vehicle is suddenly accelerated or suddenly stopped from a normal driving state, the heat generated by the semiconductor device 20 suddenly increases and causes the inverter to experience heat loss that is three to five times greater than the normal rating within a short period of one second or less. The forcible cooling performed by the heat sink 40 cannot sufficiently cope with the large amount of heat generated during such an abnormal state.

In the heat mass member 30, the thickness t2 of the heat mass portion 32 is greater than the thickness t1 of the stress reduction portion 31, and the thickness t3 of the heat mass member 30 as a whole is greater than three millimeters. Thus, even if the heat generated by the semiconductor device 20 suddenly increases, the thermal resistance is prevented from being increased and heat is efficiently dissipated.

The heat mass portion 32 temporarily absorbs heat that cannot be instantaneously dissipated by the heat sink 40. Subsequently, when returning to the normal driving state, the heat of the heat mass portion 32 is transferred to the heat sink 40 and dissipated.

The operation of the heat mass member 30 will now be described in detail together with the results of a simulation.

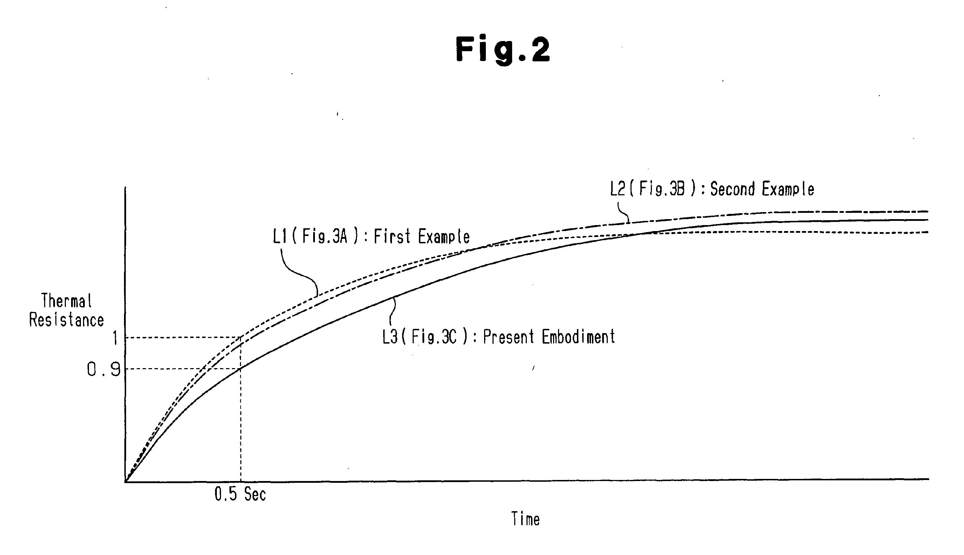

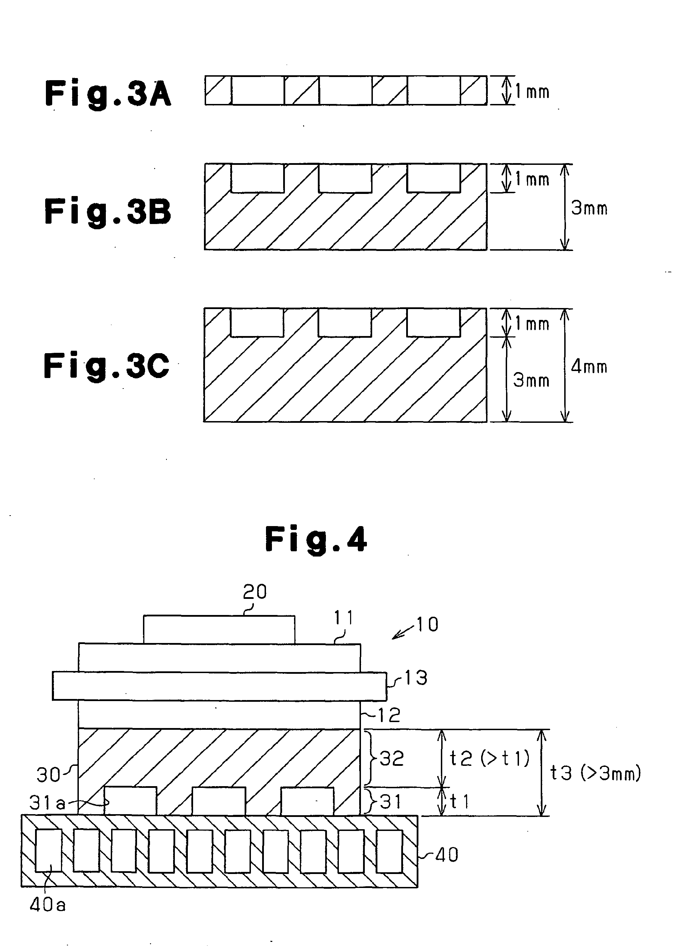

Fig. 2 shows the variation of the thermal resistance as time elapses during a simulation using each of samples shown in Figs. 3A, 3B, and 3C as a heat mass member arranged between an insulation substrate and a heat sink.

The sample of Fig. 3A is an aluminum plate having a thickness of one millimeter and includes a plurality of through holes. In Fig. 2, characteristic line L1 shows the simulation result for the sample of Fig. 3A. The sample of Fig. 3A serves as a first example compared with the present embodiment.

The sample of Fig. 3B is an aluminum plate having a thickness of three millimeters and includes a plurality of recesses having a depth of one millimeter. In Fig. 2, characteristic line L2 shows the simulation result for the sample of Fig. 3B. The sample of Fig. 3B serves as a second example compared with the present embodiment.

The sample of Fig. 3C is an aluminum plate having a thickness of four millimeters and includes a plurality of recesses having a depth of one millimeter. In Fig. 2, characteristic line L3 shows the simulation result for the sample of Fig. 3C. The sample of Fig. 3C corresponds to the present embodiment.

As shown by characteristic lines L1 and L2 in Fig. 2, the thermal resistance of the second example is slightly lower than the first example when 0.5 seconds elapses from when the heated body starts to generate heat. Comparatively, as show by characteristic line L3, in the present embodiment, the thermal resistance is lower than the first example and second example when 0.5 seconds elapses from when the heated body starts to generate heat. Thus, in the present embodiment represented by characteristic line L3, the thickness of the heat mass portion 32 in the heat mass member 30 is optimized to prevent the thermal resistance from increasing within a short period of time from when the heated body starts to generate heat.

During a short period such as a few seconds from when the heated body starts to generate heat, the heat mass member shown in Fig. 3A is not as effective as the heat mass member 30 of the present embodiment shown in Fig. 3C for preventing the thermal resistance from increasing. The heat mass member shown in Fig. 3B is also not as effective as the heat mass member 30 of the present embodiment shown in Fig. 3C for preventing the thermal resistance from increasing. Accordingly, the heat mass member 30 of the present embodiment efficiently prevents the thermal resistance from increasing within a short period of time from when the heated body starts to generate heat.

When the heat mass portion 32 in the heat mass member 30 is too thick, the saturated thermal resistance becomes high. Therefore, it is preferable that the thickness t3 of the heat mass member 30 have an upper limit of ten millimeters.

The preferred embodiment has the advantages described below.

The aluminum heat mass member 30 is arranged between the heat sink 40, which is an aluminum liquid cooling device, and the aluminum metal layer 12 of the insulation substrate 10. Further, the heat mass member 30 is metal-bonded to the insulation substrate 10 and the heat sink 40. The thickness t2 of the heat mass portion 32 is greater than the thickness t1 of the stress reduction portion 31, which is a region in which the recesses 31a are formed. Further, the thickness t3 of the heat mass member 30 is greater than three millimeters. The heat mass member 30 is formed from aluminum, which is less expensive than AlSiC. This lowers the cost of the heat dissipation apparatus. Further, the heat mass portion 32 of the heat mass member 30 prevents the thermal resistance from increasing and efficiently dissipates heat even when the heat generated by the heated body suddenly increases.

In the heat mass member 30 of Fig. 1, the recesses 31a are formed in the surface of the heat mass member 30 facing toward the insulation substrate 10. However, as shown in Fig. 4, the recesses 31a may be formed in the surface of the heat mass member 30 facing toward the heat sink 40. Alternatively, as shown in Fig. 5, the recesses 31a may be formed in the heat mass member 30 in the surface facing toward the insulation substrate 10 and the surface facing toward the heat sink 40. In this manner, the stress reduction portion 31 is required to be arranged in the heat mass member 30 in at least only one of the surfaces facing toward the insulation substrate 10 and the heat sink 40.

Coolant flows through the heat sink 40, which serves as a liquid cooling device. Instead, other cooling liquids such as alcohol may flow through the heat sink 40.

In the above-described embodiment, the thickness t2 of the heat mass portion is greater than the thickness t1 of the stress reduction portion. It is preferable that the thickness t2 of the heat mass portion be at least two times greater than the thickness of the stress reduction portion.

The present examples and embodiments are to be considered as illustrative and not restrictive, and the invention is not to be limited to the details given herein, but may be modified within the scope and equivalence of the appended claims.

A heat dissipation apparatus including an insulation substrate, a heat sink, and a heat mass member. The insulation substrate includes a first surface serving as a heated body receiving surface and a second surface opposite to the first surface. A heat sink is thermally coupled to the second surface of the insulation substrate. A heat mass member includes a stress reduction portion and a heat mass portion arranged so that one is above the other. The stress reduction portion includes a plurality of recesses in at least either one of a surface facing toward the insulation substrate and a surface facing toward the heat sink of the heat mass member. The heat mass portion has a thickness that is greater than that of the stress reduction portion, and the heat mass member has a thickness that is greater than three millimeters.

## Claims

1. A heat dissipation apparatus comprising:
an insulation substrate (10) including a first surface serving as a heated body receiving surface and a second surface opposite to the first surface, with a metal circuit layer (11) formed on the first surface and a metal layer (12) of aluminum formed on the second surface;
a heat sink (40) thermally coupled to the second surface of the insulation substrate (10), with the heat sink (40) being formed from aluminum and serving as a liquid cooling device including a cooling passage (40a); and
a heat mass member (30) formed from aluminum and arranged between the metal layer (12) of the insulation substrate (10) and the heat sink (40), with the heat mass member (30) being metal-bonded to the insulation substrate (10) and the heat sink (40),
**characterized in that** the heat mass member (30) includes a stress reduction portion (31) and a heat mass portion (32) arranged so that one is above the other, the stress reduction portion (31) includes a plurality of recesses (31a) in at least either one of a surface facing toward the insulation substrate (10) of the heat mass member (30) and a surface facing toward the heat sink (40), the heat mass portion (32) has a thickness (t2) that is greater than that (t1) of the stress reduction portion (31), and the heat mass member (30) has a thickness (t3) that is greater than three millimeters.

2. The heat dissipation apparatus according to claim 1, **characterized in that** the thickness (t2) of the heat mass portion (32) is at least two times greater than the thickness (t1) of the stress reduction portion (31).

3. The heat dissipation apparatus according to claim 1 or 2, **characterized in that** the heated body receiving surface includes a surface for receiving a semiconductor device (20).

## Patentansprüche

1. Wärmeableitungsvorrichtung mit:
einem Isolierungssubstrat (10), das eine als Aufnahmefläche für einen erwärmten Körper dienende erste Fläche und eine der ersten Fläche entgegengesetzte zweite Fläche aufweist, wobei an der ersten Fläche eine Metallschaltkreisschicht (11) ausgebildet ist und an der zweiten Fläche eine Metallschicht (12) aus Aluminium ausgebildet ist;
eine Wärmesenke (40), die thermisch an die zweite Fläche des Isolationssubstrats (10) gekoppelt ist, wobei die Wärmesenke (40) aus Aluminium ausgebildet ist und als eine Flüssigkeitskühlvorrichtung dient, die einen Kühldurchlass (40a) aufweist; und
ein Wärmemassenelement (30), das aus Aluminium ausgebildet und zwischen der Metallschicht (12) des Isolierungssubstrats (10) und der Wärmesenke (40) angeordnet ist, wobei das Wärmemassenelement (30) an das Isolierungssubstrat (10) und die Wärmesenke (40) metallverklebt ist, **dadurch gekennzeichnet, dass**
das Wärmemassenelement (30) einen
Spannungsverringerungsabschnitt (31) und einen Wärmemassenabschnitt (32) aufweist, die so angeordnet sind, dass einer über dem anderen liegt, wobei der Spannungsverringerungsabschnitt (31) eine Vielzahl von Vertiefungen (31a) zumindest in der dem Isolierungssubstrat (10) des Wärmemassenelements (30) zugewandten Fläche und/oder einer der Wärmesenke (40) zugewandten Fläche hat, wobei der Wärmemassenabschnitt (32) eine Dicke (t2) hat, die größer als jene (t1) des Spannungsverringerungsabschnitts (31) ist, und das Wärmemassenelement (30) eine Dicke (t3) hat, die größer als 3 mm ist.

2. Wärmeableitungsvorrichtung gemäß Anspruch 1, **dadurch gekennzeichnet, dass** die Dicke (t2) des Wärmemassenabschnitts (32) zumindest zweimal größer als die Dicke (t1) des Spannungsverringerungsabschnitts (31) ist.

3. Wärmeableitungsvorrichtung gemäß Anspruch 1 oder 2, **dadurch gekennzeichnet, dass** die Aufnahmefläche für den erwärmten Körper eine Fläche zum Aufnehmen einer Halbleitervorrichtung (20) aufweist.

## Revendications

1. Appareil de dissipation de chaleur comprenant :
un substrat d'isolation (10) comportant une première surface servant de surface de réception de corps chauffé et une deuxième surface opposée à la première surface, avec une couche de circuit métallique (11) formée sur la première surface et une couche métallique (12) d'aluminium formée sur la deuxième surface ;
un puits thermique (40) thermiquement couplé à la deuxième surface du substrat d'isolation (10), le puits thermique (40) étant réalisé en aluminium et servant de dispositif de refroidissement de liquide comportant un passage de refroidissement (40a) ; et
un élément (30) de masse thermique réalisé en aluminium et agencé entre la couche métallique (12) du substrat d'isolation (10) et le puits thermique (40), l'élément (30) de masse thermique étant lié à l'aide d'un métal au substrat d'isolation (10) et au puits thermique (40),
**caractérisé en ce que** l'élément (30) de masse thermique comporte une partie (31) de réduction de contrainte et une partie (32) de masse thermique agencées de sorte que l'une soit au-dessus de l'autre, la partie (31) de réduction de contrainte comporte une pluralité d'évidements (31a) dans au moins l'une ou l'autre d'une surface regardant vers le substrat d'isolation (10) de l'élément (30) de masse thermique et d'une surface regardant vers le puits thermique (40), la partie (32) de masse thermique a une épaisseur (t2) qui est supérieure à celle (t1) de la partie (31) de réduction de contrainte, et l'élément (30) de masse thermique a une épaisseur (t3) qui est supérieure à trois millimètres.

2. Appareil de dissipation de chaleur selon la revendication 1, **caractérisé en ce que** l'épaisseur (t2) de la partie (32) de masse thermique est au moins deux fois plus grande que l'épaisseur (t1) de la partie (31) de réduction de contrainte.

3. Appareil de dissipation de chaleur selon la revendication 1 ou 2, **caractérisé en ce que** la surface de réception de corps chauffé comporte une surface destinée à recevoir un dispositif semi-conducteur (20).
